# EUROPEAN PATENT SPECIFICATION

(11) **EP 2 402 776 B1**
(45) Date of publication and mention of the grant of the patent: **06.01.2016**
(21) Application number: 10167701.1
(22) Date of filing: 29.06.2010
(51) Int. Cl.: G01R 31/42, G01R 31/34

(54) **A method for indicating energy efficiency of an electric drive apparatus, and an electric drive apparatus**
Verfahren zur Anzeige der Energieeffizienz einer elektrischen Antriebsvorrichtung und elektrische Antriebsvorrichtung
Procédé pour indiquer l'efficacité énergétique d'un entraînement électrique et appareil d'entraînement électrique

(43) Date of publication of application: 04.01.2012
(73) Proprietor: ABB Oy, 00380 Helsinki (FI)
(72) Inventor: Annala, Leo, 02140 Espoo (FI)
(74) Representative: Kolster Oy Ab

(56) References cited:
- US-B1- 6 678 620
- Energywin Technology Company: "An Overview of Our Technology", , 26 December 2009 (2009-12-26), pages 1-1, XP002613375, Retrieved from the Internet: URL:http://www.energywin-tech.com/en/servi ces1.html [retrieved on 2010-12-08] -& "WebDate - screenshot establishing the date of the latest modification of the webpage of XP002613375", DIGITAL-DETECTIVE.CO.UK, 26 December 2009 (2009-12-26), XP002613377, WEBDATE
- ABB: "Measure, monitor and save energy with pumps and fans using ABB drives", , 2009, pages 1-2, XP002613382, Retrieved from the Internet: URL:http://www05.abb.com/global/scot/scot2 01.nsf/veritydisplay/1f23a83d7852df53c1257 5a20022e765/$File/ProductNotePD22_EnergyEf ficiency_param_RevA_EN_lowres.pdf [retrieved on 2010-12-08]
- "Showcase Demonstration case study", INTERNET CITATION, September 1996 (1996-09), XP002216358, Retrieved from the Internet: URL:http://www.oit.doe.gov/bestpractices/m otors/factsheets/mc-cs02.pdf [retrieved on 2002-10-08]

## Description

### FIELD OF THE INVENTION

The present invention relates to the field of electric drives used for industrial applications, such as for applications within the transportation industry, energy industry, process industry and manufacturing industry, and more particularly to a method for indicating energy efficiency of an electric drive apparatus and to an electric drive apparatus.

### BACKGROUND OF THE INVENTION

Electric drives are used in industry for different applications, such as for driving motors within the transportation industry, for driving different devices within the process and manufacturing industry as well as within the energy industry. There are applications commonly used for electric drives within the transportation industry for example in metro and railway traffic applications as well as in ship propulsion unit applications of the marine industry. Within the process and manufacturing industry, electric drives can be used for example in conveyer applications, in mixer applications or even in paper machine applications. Within the energy industry, electric drives can be used for example as electric drives for wind turbines of the wind power industry and as electric drives of the solar power industry.

Electric drives for electric motors may be divided into DC motor drives (DC, direct current) and AC drives (AC, alternating current). In a DC motor of a DC motor drive, a magnetic field is generated by the current through the field winding in the stator. This magnetic field is always maintained at right angles to the field generated by the armature winding. In this way, a DC motor's torque is generated, which torque can then be easily controlled in a DC motor drive by changing the armature current and keeping the magnetizing current constant. In a DC motor drive, also the DC motor speed can be controlled directly through armature current.

Within electric drives, the AC drives may further be divided into frequency-controlled AC drives, flux-vector-controlled AC drives and into AC drives utilising direct torque control (DTC, Direct Torque Control). In flux-vector-controlled AC drives and in direct torque control AC drives the torque of the three-phase motor can be controlled, whereas in frequency controlled AC drives the load dictates the torque level.

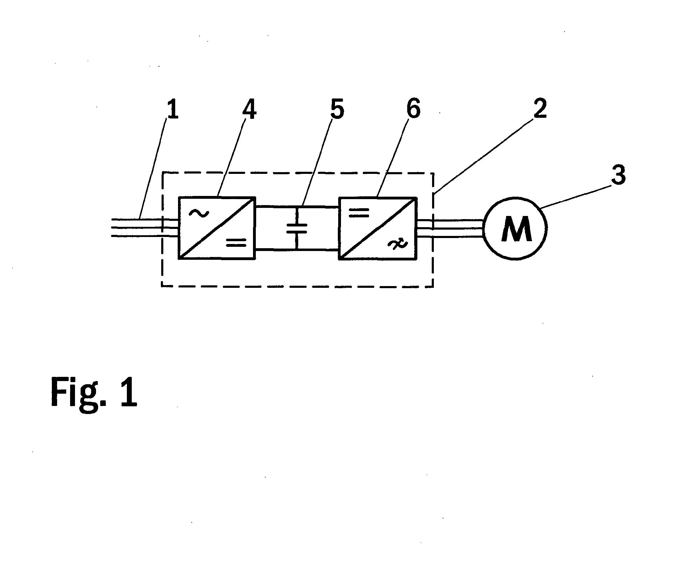

In the following, the prior art will be described with reference to the accompanying Figure 1, which shows a block diagram of an electric drive according to prior art.

Figure 1 shows a block diagram of an electric drive according to prior art. The electric drive according to prior art comprises an input power feed 1, a frequency controller 2 and a load 3. The load 3 can be for example a motor 3. The frequency controller 2 typically comprises a rectifier unit 4, a fixed DC voltage intermediate circuit 5 and an inverter unit 6. The rectifier unit 4 of the frequency controller 2 converts the AC input power coming from the input power feed 1 into DC intermediate power. The rectifying in the frequency controller 2 can be realised for example with a 6-pulse diode bridge. The DC intermediate power coming from the rectifier unit 4 of the frequency controller 2 is stored in the fixed DC voltage intermediate circuit 5 acting as intermediate energy storage. The fixed DC voltage intermediate circuit 5 of the frequency controller 2 can be realised for example with capacitors. The inverter unit 6 of the frequency controller 2 converts the DC power of the fixed DC voltage intermediate circuit 5 into three channels of AC energy at the frequency suited by the motor 3 acting as a load 3. The inverter unit 6 of the frequency controller 2 can be realised for example with IGBT transistors (IGBT, Insulated-gate bipolar transistor).

Electric drives are typically used in very demanding applications. Especially, in most of the applications used, the demand to save energy is constantly increasing. When electric drives are used in an application to drive the load, e.g. a motor, optimally, energy will be saved considerably. On the other hand, when electric drives are not used correctly in an application, energy savings will not be that great. In a typical electric drive application, there are several subsystems in the electric drive and in the application setting that may all contribute to the overall energy efficiency of the electric drive application. For example in Figure 1, the functioning of the rectifier unit 4, the fixed DC voltage intermediate circuit 5 and the inverter unit 6 as subsystems 4 to 6 of the frequency controller 2 as well as the functioning of the input power feed 1 and the load 3 may all contribute to the overall energy efficiency of the particular electric drive application.

There are several ways to address the energy efficiency of the particular electric drive application. The energy savings contributed by better energy efficiency may be compared to a maximum consumption value, to a nominal consumption value or even to the consumption of another electric drive application. Typically, the current energy efficiency is of interest. As mentioned earlier, also changes in the application setting may substantially contribute to the overall energy efficiency of the electric drive application. For example, with an electric drive in a pump application, the flow rate can have a dramatic influence to the accumulated energy savings. When the flow rate is close to a maximum value, the motor runs close to a nominal speed and the savings are minimal. On the other hand, when the flow rate is half of the maximum value, the motor is running at a more optimal speed and a substantial amount of energy can be saved. A more detailed explanation of energy consumption in an electric device can be found in a European Patent specification EP 15489235 B1.

A prior art web-page of Energywin Technology Company titled "An Overview Of Our Technology" (see Internet http://www.energywin-tech.com/en/services1.html) discloses a typical prior art automatic control system including a touch screen display for numerically displaying the operating status and instantaneous energy consumption and efficiency of the operated pumps.

A prior art brochure of ABB titled "Measure, monitor and save energy with pumps and fans using ABB drives" discloses a prior art AC drive system, where first a baseline for energy savings is determined for an AC drive, and thereafter calculated energy savings in kWh or MWh with reference to said baseline is numerically displayed.

A prior art US Patent document US 6,678,620 B1 discloses a typical prior art solution, where e.g. an inverter is introduced to an existing pump arrangement and thereafter the energy-saving effect of the introduced inverter is communicated to the user.

The application user typically installs electric drives for very demanding applications and may not feel confident that the application setting and the electric drives, in particular, are installed correctly in regard to the energy consumption. Furthermore, the process settings or the intended use may change over a period of time in the application where the electrical drives are installed. All these factors make the application user wonder whether the electric drives are functioning properly in regard to the energy consumption.

In today's demanding environment, the application user having the electrical drives in an application would like to know what the energy efficiency of a particular electrical drive installed in his application is. This kind of information is vital to the application user and he would like to receive this information constantly and without too much extra effort. There is a demand in the market for a method for indicating energy efficiency of an electric drive as well as for electric drives that would be able to communicate their energy efficiency better than the current prior art solutions.

### BRIEF DESCRIPTION OF THE INVENTION

An object of the present invention is thus to provide a method and an apparatus for implementing the method so as to overcome the above problems and to alleviate the above disadvantages.

The objects of the invention are achieved by a method for indicating energy efficiency of an electric drive, which method further comprises the steps of:
- collecting data relevant to the energy efficiency of the electric drive,
- user selecting the way to address the energy efficiency of the said electric drive and selecting the applicable standard values for energy efficiency,
- determining the energy efficiency of the electric drive by analysing the collected energy efficiency data together with the said user selected way to address the energy efficiency of the said electric drive and the said user selected applicable standard values set for energy efficiency, and
- indicating the energy efficiency to the user with the help of light in a specific indication light area of the cabinet of the electric drive apparatus, so that LED lights of the same colour, e.g. green, are used with different light intensities for indicating specific energy efficiency values or energy efficiency grades.

Preferably, in the step of selecting the user selects the said way to address the energy efficiency based on the recent energy savings contributed by better energy efficiency being compared to a maximum consumption value, to a nominal consumption value or to the consumption of another electric drive.

Preferably, in the step of collecting data, said energy efficiency data is collected from the various subsystems in the electric drive and/or in the application setting.

Preferably, in the step of determining the energy efficiency, said determined energy efficiency is a specific energy efficiency value or an energy efficiency grade from a set of energy efficiency grades.

Preferably, in the step of indicating the energy efficiency, a particular colour selected is used for indicating a fault or a need for maintenance.

Furthermore, the objects of the invention are achieved by an electric drive apparatus which has:
- a data collection unit for collecting data relevant to the energy efficiency of the electric drive,
- a determination unit for determining the energy efficiency of the electric drive by analysing the collected energy efficiency data together with the user selected way to address the energy efficiency of the said electric drive and user selected applicable standard values set for energy efficiency, and
- an indication unit for indicating the energy efficiency to the user with the help of light in a specific indication light area of the cabinet of the electric drive apparatus, so that the indication unit has a light arrangement with LED lights of the same colour, e.g. green, used with different light intensities for indicating specific energy efficiency values or energy efficiency grades.

Preferably, said user selected way to address the energy efficiency is based on the recent energy savings contributed by better energy efficiency being compared to a maximum consumption value, to a nominal consumption value or to the consumption of another electric drive.

Preferably, said determined energy efficiency is specified as a specific energy efficiency value or an energy efficiency grade from a set of energy efficiency grades.

Preferably, said indication unit uses HPLED lights in the light arrangement.

Preferably, said indication unit includes a light guide arrangement. Preferably, said indication unit indicates a fault or a need for maintenance with a particular colour selected.

Preferably, said electric drive apparatus is provided with a possibility to update the applicable standard values previously set for energy efficiency.

Preferably, said indication light area is in the lower part of the cabinet, in the upper part of the cabinet, in the central part of the cabinet, in the area extending vertically from the upper part to the lower part in front of the cabinet, in the front area of the cabinet or in the entire enclosure of the cabinet.

Preferably, said electric drive apparatus is a frequency converter.

### BRIEF DESCRIPTION OF THE DRAWINGS

Figure 1 shows a block diagram of an electric drive according to prior art;
Figure 2 shows a block diagram of an energy efficiency indication arrangement of an electric drive apparatus according to the present invention;
Figure 3 shows a flow diagram of a method for indicating energy efficiency of an electric drive according to the present invention;
Figure 4 shows one embodiment of an electric drive apparatus according to the present invention;
Figure 5 shows another embodiment of an electric drive apparatus according to the present invention;
Figure 6 shows a third embodiment of an electric drive apparatus according to the present invention;
Figure 7 shows a fourth embodiment of an electric drive apparatus according to the present invention.
Figure 8 shows a fifth embodiment of an electric drive apparatus according to the present invention.
Figure 9 shows a sixth embodiment of an electric drive apparatus according to the present invention.

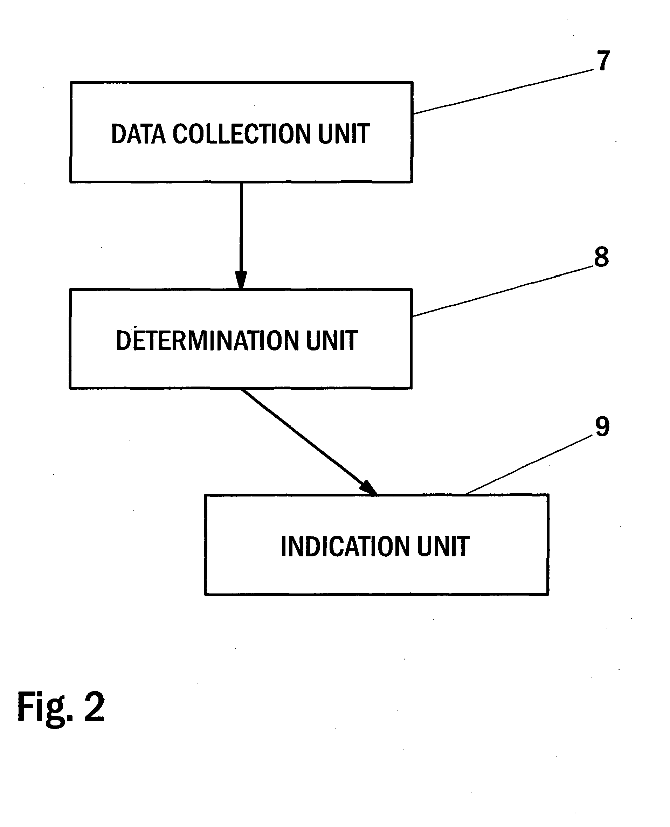

The prior art drawing of Figure 1 has been presented earlier. In the following, the invention will be described in greater detail by means of preferred embodiments with reference to the accompanying drawings of Figures 2 to 9.

### DETAILED DESCRIPTION OF THE INVENTION

Figure 2 shows a block diagram of an energy efficiency indication arrangement of an electric drive apparatus according to the present invention. In regard to the energy efficiency indication arrangement, the electric drive apparatus according to the present invention has a data collection unit 7, a determination unit 8 and an indication unit 9. First, the data collection unit 7 of the electric drive apparatus collects the data relevant to the energy efficiency of the electric drive. The energy efficiency data may be collected from the various subsystems in the electric drive and in the application setting, these including electric drive subsystems, the input power feed and the load. The data collection unit 7 of the electric drive apparatus according to the present invention may also be used for gathering data for other purposes than for collecting the energy efficiency data. The data collection unit 7 then forwards the energy efficiency data to the determination unit 8. Alternatively, the data collection unit 7 stores the energy efficiency data to memory storage from which the determination unit 8 can access the energy efficiency data. The data collection unit 7 may edit or further process the collected energy efficiency data before forwarding the energy efficiency data to the determination unit 8 or storing the energy efficiency data to the memory storage.

The determination unit 8 of the electric drive apparatus according to the present invention analyses the collected energy efficiency data together with the applicable standard values previously set for energy efficiency and determines the energy efficiency of the electric drive apparatus. The user may select the appropriate way to address the energy efficiency of the particular electric drive application and select the applicable standard values for energy efficiency accordingly. The recent energy savings contributed by better energy efficiency may be compared to a maximum consumption value, to a nominal consumption value or even to the consumption of another electric drive application. Because the changes in the electric drive and in its subsystems as well as the changes in the application setting may substantially contribute to the overall energy efficiency of the electric drive application, all relevant collected energy efficiency data is considered in the determination process. The determined energy efficiency can be specified as a specific energy efficiency value or an energy efficiency grade from a set of energy efficiency grades, e.g. grades A-F. The determination unit 8 of the electric drive apparatus according to the present invention may also be used for processing data for other purposes than for processing energy efficiency data. The electric drive apparatus according to the present invention may be provided with a possibility to update the previously set applicable standard values for energy efficiency. The determination unit 8 then forwards the determined energy efficiency to the indication unit 9.

The indication unit 9 of the electric drive apparatus according to the present invention indicates the energy efficiency of the electric drive apparatus to the user with the help of light. The indication unit 9 may include a light arrangement for indicating the energy efficiency of the electric drive apparatus to the user with the help of light. The light arrangement of the indication unit 9 may be any known light arrangement suitable for producing light that can be properly made visible to the user. The light arrangement of the indication unit 9 may also be a standard LED light arrangement (LED, Light-Emitting Diode). The light arrangement may have LED lights of the same colour used with different light intensities for indicating specific energy efficiency values or energy efficiency grades with different colours. Alternatively, the light arrangement may have several LED lights of different colours for indicating specific energy efficiency values or energy efficiency grades with different colours. The green colour may be selected to indicate good energy efficiency. Likewise, the red colour may be selected to indicate poor energy efficiency. The indication unit 9 of the electric drive apparatus according to the present invention may also indicate a fault or a need for maintenance with a particular selected colour, e.g. red light indication. The light arrangement of the indication unit 9 may also be an HPLED light arrangement (HPLED, High-Power LED). The light arrangement of the indication unit 9 may also be based on any known technology suitable for producing light that can be properly made visible to the user. The indication unit 9 of the electric drive apparatus according to the present invention may also include a light guide arrangement to properly bring the light of the light arrangement visible to the user. The indication unit 9 of the electric drive apparatus according to the present invention may also use different light intensities for indicating specific energy efficiency values or energy efficiency grades.

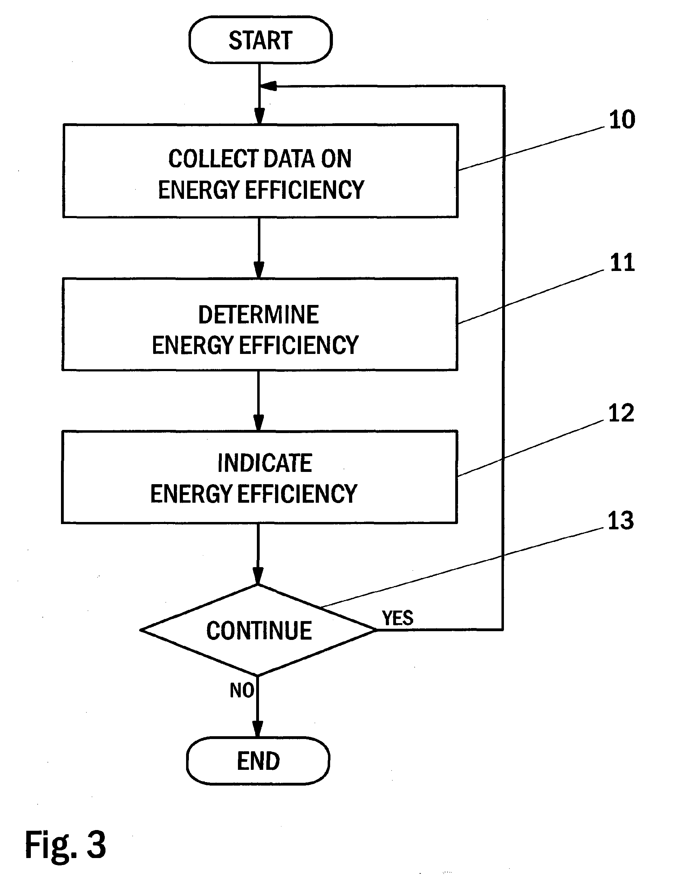

Figure 3 shows a flow diagram of a method for indicating energy efficiency of an electric drive according to the present invention. In the method for indicating energy efficiency of an electric drive according to the present invention, the data collection unit 7 first collects 10 data relevant to the energy efficiency of the electric drive. The energy efficiency data may be collected 10 from the various subsystems in the electric drive and in the application setting, these including electric drive subsystems, the input power feed and the load. The data collection unit 7 then forwards the energy efficiency data to a determination unit 8 or stores the energy efficiency data to memory storage from which the determination unit 8 can access the energy efficiency data. The collected energy efficiency data may be edited or further processed by the data collection unit 7 before being forwarded to the determination unit 8 or stored to the memory storage.

In the method for indicating energy efficiency of an electric drive according to the present invention, the determination unit 8 analyses the collected energy efficiency data together with the applicable standard values set for energy efficiency and determines 11 the energy efficiency of the electric drive. The user may select that the recent energy savings contributed by better energy efficiency are compared to a maximum consumption value, to a nominal consumption value or even to the consumption of another electric drive application. All relevant energy efficiency data collected is considered in the determination process. The determined energy efficiency can be specified as a specific energy efficiency value or an energy efficiency grade from a set of energy efficiency grades, e.g. grades A-F. The determination unit 8 then forwards the determined energy efficiency to an indication unit 9.

In the method for indicating energy efficiency of an electric drive according to the present invention, the indication unit 9 indicates 12 the energy efficiency to the user with the help of light. The indication unit 9 may include a light arrangement for indicating 12 the energy efficiency of the electric drive to the user. The light arrangement of the indication unit 9 may be a standard LED light arrangement and have LED lights of the same colour used with different light intensities for indicating specific energy efficiency values or energy efficiency grades with different colours. Alternatively, the light arrangement may have several LED lights of different colours for indicating specific energy efficiency values or energy efficiency grades with different colours. The green colour may be selected to indicate 12 good energy efficiency. In the method for indicating energy efficiency of an electric drive according to the present invention, the indication unit 9 may also indicate a fault or a need for maintenance with a particular colour selected, e.g. red light indication. The indication unit 9 may also include a light guide arrangement to properly bring the light of the light arrangement visible to the user.

In the method for indicating energy efficiency of an electric drive according to the present invention, the process of collecting 10 data and determining 11 and indicating 12 energy efficiency is repeated continuously and continued 13 until the electric drive apparatus is turned off or until the energy efficiency indication feature is turned off.

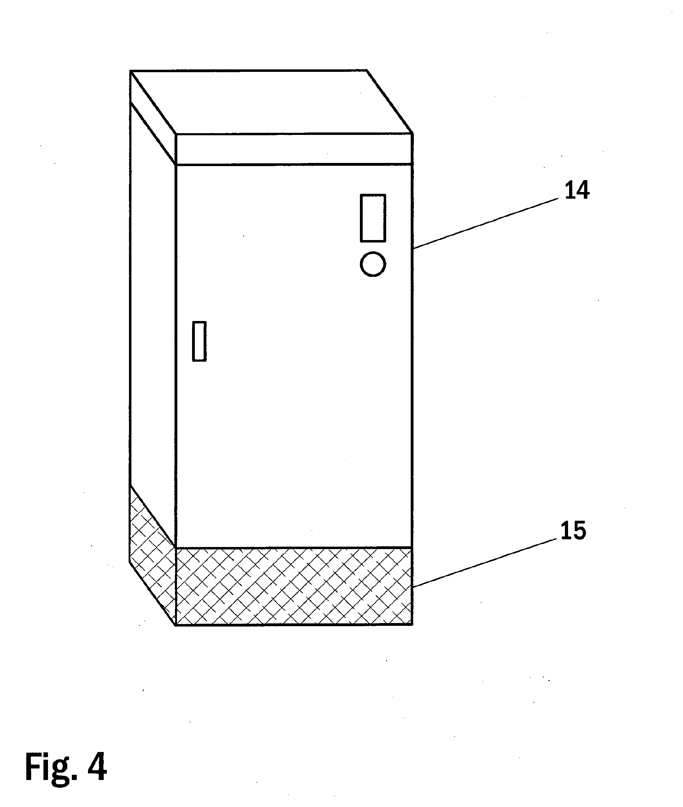

Figure 4 shows one embodiment of an electric drive apparatus according to the present invention. The electric drive apparatus according to the present invention is indicated in Figure 4 by number 14. The electric drive apparatus has a specific indication light area. The electric drive apparatus according to one embodiment of the present invention has an indication light area 15 in the lower part of the cabinet. When the power of the electric drive apparatus is turned on, the indication light area 15 in the lower part of the cabinet will be lit. The indication light area 15 can e.g. light up the lower edge of the heat sink and provide a green glow in the lower part of the cabinet.

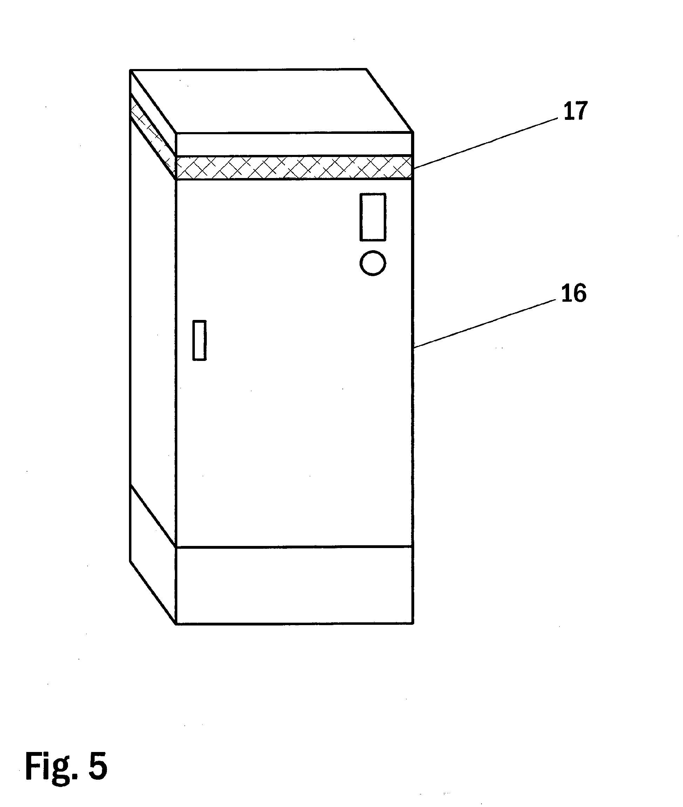

Figure 5 shows another embodiment of an electric drive apparatus according to the present invention. The electric drive apparatus according to the present invention is indicated in Figure 5 by number 16. The electric drive apparatus according to another embodiment of the present invention has an indication light area 17 in the upper part of the cabinet.

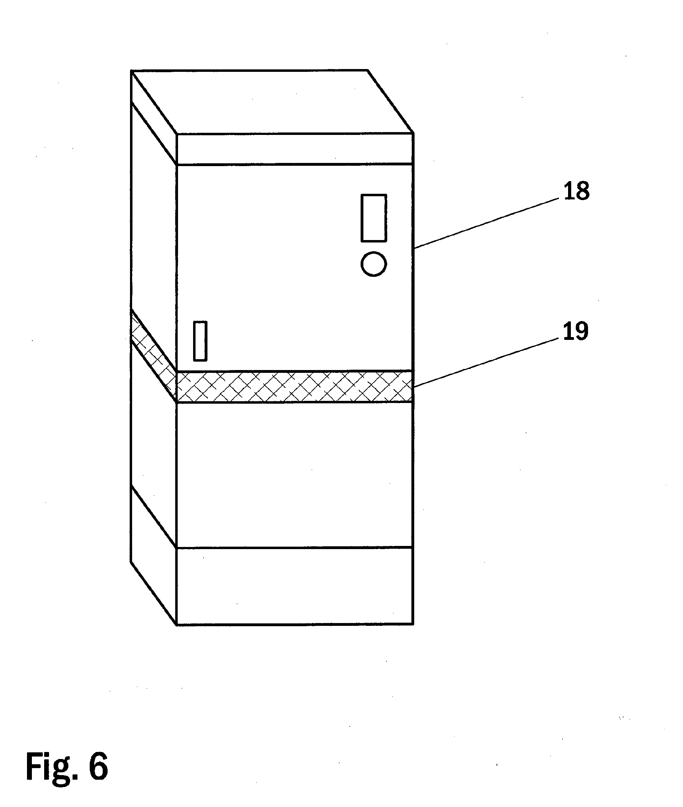

Figure 6 shows a third embodiment of an electric drive apparatus according to the present invention. The electric drive apparatus according to the present invention is indicated in Figure 6 by number 18. The electric drive apparatus according to the third embodiment of the present invention has an indication light area 19 in the central part of the cabinet.

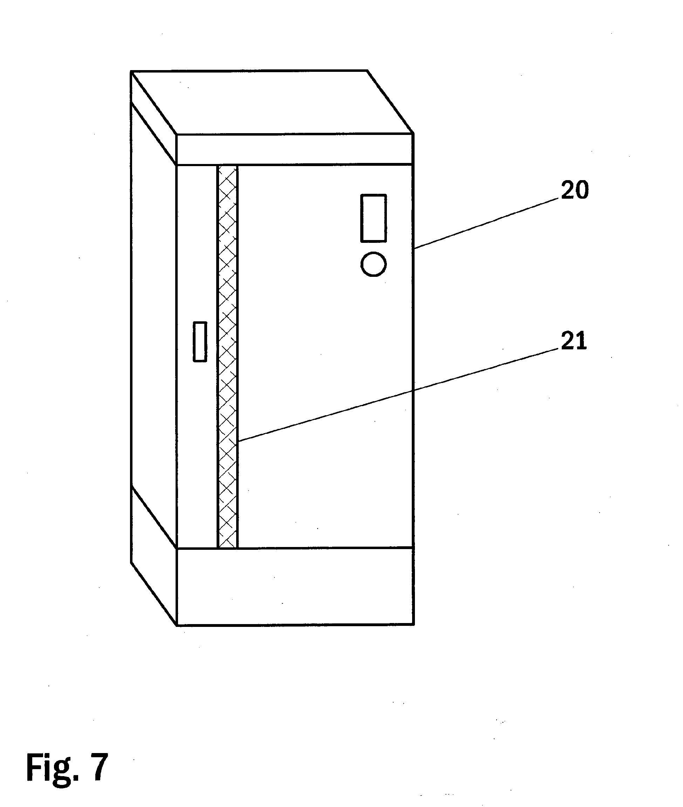

Figure 7 shows a fourth embodiment of an electric drive apparatus according to the present invention. The electric drive apparatus according to the present invention is indicated in Figure 7 by number 20. The electric drive apparatus according to the fourth embodiment of the present invention has an indication light area 21 in the area extending vertically from upper part to the lower part in front of the cabinet.

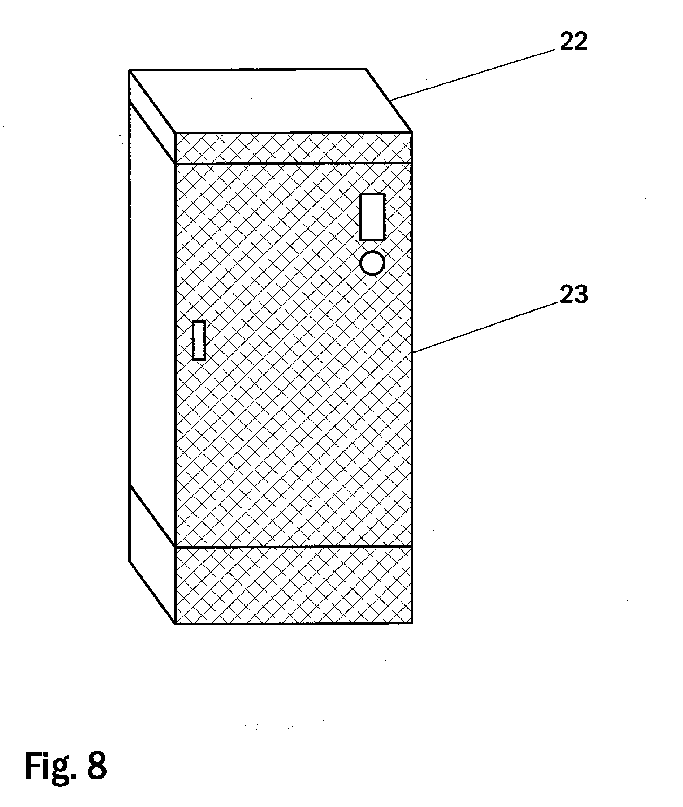

Figure 8 shows a fifth embodiment of an electric drive apparatus according to the present invention. The electric drive apparatus according to the present invention is indicated in Figure 8 by number 22. The electric drive apparatus according to the fifth embodiment of the present invention has an indication light area 23 covering the front of the cabinet.

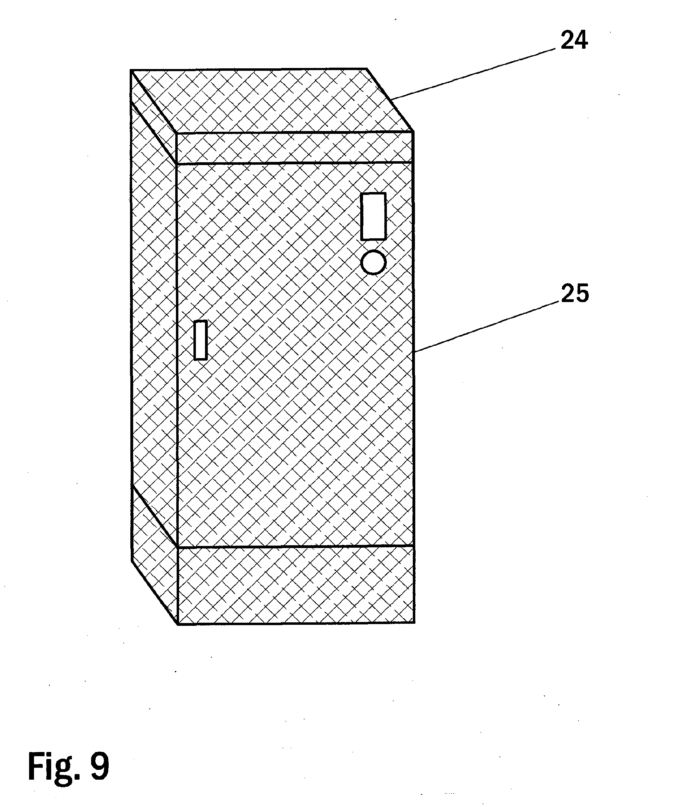

Figure 9 shows a sixth embodiment of an electric drive apparatus according to the present invention. The electric drive apparatus according to the present invention is indicated in Figure 9 by number 24. The electric drive apparatus according to the sixth embodiment of the present invention has an indication light area 25 covering the entire enclosure of the cabinet.

With the help of the solution according to the present invention the application user having electric drives in an application will know at a glance what the energy efficiency of a particular electric drive installed in his application is.

With the help of the solution according to the present invention, a properly functioning electric drive apparatus will provide a green glow indicating to the user that energy is being saved. The solution according to the present invention may be utilised in e.g. frequency converters or in any electric drive apparatuses.

It will be obvious to a person skilled in the art that, as the technology advances, the inventive concept can be implemented in various ways. The invention and its embodiments are not limited to the examples described above but may vary within the scope of the claims.

## Claims

1. A method for indicating energy efficiency of an electric drive, comprising the steps of:
- collecting (10) data relevant to the energy efficiency of the electric drive,
- user selecting the way to address the energy efficiency of the said electric drive and selecting the applicable standard values for energy efficiency,
- determining (11) the energy efficiency of the electric drive by analysing the collected energy efficiency data together with the said user selected way to address the energy efficiency of the said electric drive and the said user selected applicable standard values set for energy efficiency, and
- indicating (12) the energy efficiency to the user with the help of light in a specific indication light area (15), (17), (19), (21) of the cabinet of the electric drive apparatus (14), (16), (18), (20), so that LED lights of the same colour, e.g. green, are used with different light intensities for indicating specific energy efficiency values or energy efficiency grades.

2. A method according to claim 1, **characterized in that** in the step of selecting the user selects the said way to address the energy efficiency based on the recent energy savings contributed by better energy efficiency being compared to a maximum consumption value, to a nominal consumption value or to the consumption of another electric drive.

3. A method according to claim 1 or claim 2, **characterized in that** in the step of collecting (10) data, said energy efficiency data is collected from the various subsystems in the electric drive and/or in the application setting.

4. A method according to any one of claims 1 to 3, **characterized in that** in the step of determining (11) the energy efficiency, said determined energy efficiency is a specific energy efficiency value or an energy efficiency grade from a set of energy efficiency grades.

5. A method according to any one of claims 1 to 4, **characterized in that** in the step of indicating (12) the energy efficiency, a particular colour selected is used for indicating a fault or a need for maintenance.

6. An electric drive apparatus, wherein said electric drive apparatus (14), (16), (18), (20) has:
- a data collection unit (7) for collecting data relevant to the energy efficiency of the electric drive,
- a determination unit (8) for determining the energy efficiency of the electric drive by analysing the collected energy efficiency data together with a user selected way to address the energy efficiency of the said electric drive and user selected applicable standard values set for energy efficiency, and
- an indication unit (9) for indicating the energy efficiency to the user with the help of light in a specific indication light area (15), (17), (19), (21) of the cabinet of the electric drive apparatus (14), (16), (18), (20), so that the indication unit (9) has a light arrangement with LED lights of the same colour, e.g. green, used with different light intensities for indicating specific energy efficiency values or energy efficiency grades.

7. An electric drive apparatus according to claim 6, **characterized in that** the said user selected way to address the energy efficiency is based on the recent energy savings contributed by better energy efficiency being compared to a maximum consumption value, to a nominal consumption value or to the consumption of another electric drive.

8. An electric drive apparatus according to claim 6 or claim 7, **characterized in that** the determined energy efficiency is specified as a specific energy efficiency value or an energy efficiency grade from a set of energy efficiency grades.

9. An electric drive apparatus according to any one of claims 6 to 8, **characterized in that** the indication unit (9) uses HPLED lights in the light arrangement.

10. An electric drive apparatus according to any one of claims 6 to 9, **characterized in that** the indication unit (9) includes a light guide arrangement.

11. An electric drive apparatus according to any one of claims 6 to 10, **characterized in that** indication unit (9) indicates a fault or a need for maintenance with a particular colour selected.

12. An electric drive apparatus according to any one of claims 6 to 11, **characterized in that** the electric drive apparatus (14), (16), (18), (20) is provided with a possibility to update the applicable standard values previously set for energy efficiency.

13. An electric drive apparatus according to any one of claims 6 to 12, **characterized in that** the indication light area (15), (17), (19), (21) is in the lower part of the cabinet (15), in the upper part of the cabinet (17), in the central part of the cabinet (19), in the area extending vertically from the upper part to the lower part in the front of the cabinet (21), in front area of the cabinet (23) or in the entire enclosure of the cabinet (25).

14. An electric drive apparatus according to any one of claims 6 to 13, **characterized in that** the electric drive apparatus (14), (16), (18), (20) is a frequency converter.

## Patentansprüche

1. Verfahren zur Anzeige der Energieeffizienz eines elektrischen Antriebs, das die Schritte aufweist, in denen:
- für die Energieeffizienz des elektrischen Antriebs relevante Daten gesammelt werden (10)
- ein Benutzer die Art und Weise für die Ausbildung der Energieeffizienz des besagten elektrischen Antriebs auswählt und die anwendbaren Standardwerte für Energieeffizienz auswählt
- die Energieeffizienz des elektrischen Antriebs bestimmt wird (11), indem die gesammelten Energieeffizienz-Daten zusammen mit der besagten von dem Benutzer ausgewählten Art und Weise für die Ausbildung der Energieeffizienz des besagten elektrischen Antriebs und den besagten von dem Benutzer ausgewählten anwendbaren Standardwerten für Energieeffizienz analysiert werden, und
- die Energieeffizienz für den Benutzer anhand von Licht in einem spezifischen Anzeigelichtbereich (15), (17), (19), (21) des Gehäuses der elektrischen Antriebsvorrichtung (14), (16), (18), (20) angezeigt wird (12), so dass gleichfarbige, z. B. grüne, LED-Lichter mit unterschiedlichen Lichtintensitäten zur Anzeige von spezifischen Energieeffizienzwerten oder Energieeffizienzklassen verwendet werden.

2. Verfahren nach Patentanspruch 1, dadurch **gekennzeich**n e t , dass im Auswahlschritt der Benutzer die besagte Art und Weise für die Ausbildung der Energieeffizienz aufgrund eines Vergleichs der kürzlichen, durch bessere Energieeffizienz geleisteten Energieeinsparungen mit einem maximalen Verbrauchswert, einem nominalen Verbrauchswert oder dem Verbrauch eines anderen elektrischen Antriebs auswählt.

3. Verfahren nach Patentanspruch 1 oder 2, dadurch **gekenn**- **zeichnet** , dass im Schritt der Datensammlung (10) die besagten Energieeffizienz-Daten von den verschiedenen Teilsystemen im elektrischen Antrieb und/oder in der Anwendungsumgebung gesammelt werden.

4. Verfahren nach einem der Patentansprüche 1 bis 3, **dadurch gekennzeichnet, dass** im Schritt der Bestimmung (11) der Energieeffizienz die besagte bestimmte Energieeffizienz ein spezifischer Energieeffizienzwert oder eine Energieeffizienzklasse aus einer Reihe von Energieeffizienzklassen ist.

5. Verfahren nach einem der Patentansprüche 1 bis 4, **dadurch gekennzeichnet, dass** im Schritt der Anzeige (12) der Energieeffizienz eine besondere ausgewählte Farbe für die Anzeige eines Fehlers oder Wartungsbedarfs verwendet wird.

6. Elektrische Antriebsvorrichtung, wobei die besagte elektrische Antriebsvorrichtung (14), (16), (18), (20) besitzt:
- eine Datensammlungseinheit (7) zur Sammlung von für die Energieeffizienz des elektrischen Antriebs relevanten Daten
- eine Bestimmungseinheit (8) zur Bestimmung der Energieeffizienz des elektrischen Antriebs, indem die gesammelten Energieeffizienz-Daten zusammen mit einer von dem Benutzer ausgewählten Art und Weise für die Ausbildung der Energieeffizienz des besagten elektrischen Antriebs und von dem Benutzer ausgewählten anwendbaren Standardwerten für Energieeffizienz analysiert werden, und
- eine Anzeigeeinheit (9) zur Anzeige der Energieeffizienz für den Benutzer anhand von Licht in einem spezifischen Anzeigelichtbereich (15), (17), (19), (21) des Gehäuses der elektrischen Antriebsvorrichtung (14), (16), (18), (20), wobei die Anzeigeeinheit (9) eine Lichtanordnung mit gleichfarbigen, z. B. grünen, LED-Lichtern hat, die mit unterschiedlichen Lichtintensitäten zur Anzeige von spezifischen Energieeffizienzwerten oder Energieeffizienzklassen verwendet werden.

7. Elektrische Antriebsvorrichtung nach Patentanspruch 6, **dadurch gekennzeichnet, dass** die besagte von dem Benutzer ausgewählte Art und Weise für die Ausbildung der Energieeffizienz auf einem Vergleich der kürzlichen, durch bessere Energieeffizienz geleisteten Energieeinsparungen mit einem maximalen Verbrauchswert, einem nominalen Verbrauchswert oder dem Verbrauch eines anderen elektrischen Antriebs basiert.

8. Elektrische Antriebsvorrichtung nach Patentanspruch 6 oder 7, **dadurch gekennzeichnet, dass** die bestimmte Energieeffizienz als ein spezifischer Energieeffizienzwert oder eine Energieeffizienzklasse aus einer Reihe von Energieeffizienzklassen spezifiziert wird.

9. Elektrische Antriebsvorrichtung nach einem der Patentansprüche 6 bis 8, **dadurch gekennzeichnet, dass** die Anzeigeeinheit (9) HPLED-Lichter in der Lichtanordnung verwendet.

10. Elektrische Antriebsvorrichtung nach einem der Patentansprüche 6 bis 9, **dadurch gekennzeichnet, dass** die Anzeigeeinheit (9) eine Lichtleiteranordnung umfasst.

11. Elektrische Antriebsvorrichtung nach einem der Patentansprüche 6 bis 10, **dadurch gekennzeichnet, dass** die Anzeigeeinheit (9) einen Fehler oder einen Wartungsbedarf mit einer besonderen ausgewählten Farbe anzeigt.

12. Elektrische Antriebsvorrichtung nach einem der Patentansprüche 6 bis 11, **dadurch gekennzeichnet, dass** die elektrische Antriebsvorrichtung (14), (16), (18), (20) mit einer Möglichkeit ausgestattet wird, die anwendbaren, für Energieeffizienz vorbestimmten Standardwerte zu aktualisieren.

13. Elektrische Antriebsvorrichtung nach einem der Patentansprüche 6 bis 12, **dadurch gekennzeichnet, dass** sich der Anzeigelichtbereich (15), (17), (19), (21) im unteren Teil des Gehäuses (15), im oberen Teil des Gehäuses (17), im mittleren Teil des Gehäuses (19), im sich vertikal von dem oberen Teil zum unteren Teil vor dem Gehäuse (21) erstreckenden Bereich, im vorderen Bereich des Gehäuses (23) oder in der gesamten Kapselung des Gehäuses (25) befindet.

14. Elektrische Antriebsvorrichtung nach einem der Patentansprüche 6 bis 13, **dadurch gekennzeichnet, dass** die elektrische Antriebsvorrichtung (14), (16), (18), (20) ein Frequenzumrichter ist.

## Revendications

1. Procédé d'indication du rendement énergétique d'une commande électrique, comprenant les étapes :
- de collecte (10) de données concernant le rendement énergétique de la commande électrique,
- de sélection, par l'utilisateur, de la manière d'aborder le rendement énergétique de ladite commande électrique et de sélection, par celui-ci, des valeurs standard applicables pour le rendement énergétique,
- de détermination (11) du rendement énergétique de la commande électrique en analysant les données de rendement énergétique collectées avec ladite manière d'aborder le rendement énergétique de ladite commande électrique sélectionnée par l'utilisateur et lesdites valeurs standard applicables sélectionnées par l'utilisateur établies pour le rendement énergétique, et
- d'indication (12) du rendement énergétique à l'utilisateur à l'aide d'un voyant dans une zone de voyants d'indication spécifique (15), (17), (19), (21) de l'armoire de l'appareil de commande électrique (14), (16), (18), (20), de sorte que des voyants à DEL de la même couleur, par exemple verte, soient utilisés avec différentes intensités de lumière pour indiquer des valeurs de rendement énergétique ou des niveaux de rendement énergétique spécifiques.

2. Procédé selon la revendication 1, **caractérisé en ce que**, à l'étape de sélection, l'utilisateur sélectionne ladite manière d'aborder le rendement énergétique sur la base des économies d'énergie récentes permises par un meilleur rendement énergétique comparées à une valeur de consommation maximum, à une valeur de consommation nominale ou à la consommation d'une autre commande électrique.

3. Procédé selon la revendication 1 ou la revendication 2, **caractérisé en ce que**, à l'étape de collecte (10) de données, lesdites données de rendement énergétique sont collectées à partir des divers sous-systèmes dans la commande électrique et/ou dans le réglage de l'application.

4. Procédé selon l'une quelconque des revendications 1 à 3, **caractérisé en ce que**, à l'étape de détermination (11) du rendement énergétique, ledit rendement énergétique déterminé est une valeur de rendement énergétique spécifique ou un niveau de rendement énergétique parmi un ensemble de niveaux de rendement énergétique.

5. Procédé selon l'une quelconque des revendications 1 à 4, **caractérisé en ce que**, à l'étape d'indication (12) du rendement énergétique, une couleur particulière sélectionnée est utilisée pour indiquer une panne ou un besoin de maintenance.

6. Appareil de commande électrique, dans lequel ledit appareil de commande électrique (14), (16), (18), (20) comporte :
- une unité de collecte de données (7) pour collecter des données concernant le rendement énergétique de la commande électrique,
- une unité de détermination (8) pour déterminer le rendement énergétique de la commande électrique en analysant les données de rendement énergétique collectées avec une manière d'aborder le rendement énergétique de ladite commande électrique sélectionnée par l'utilisateur et des valeurs standard applicables sélectionnées par l'utilisateur fixées pour le rendement énergétique, et
- une unité d'indication (9) pour indiquer le rendement énergétique à l'utilisateur à l'aide d'un voyant dans une zone de voyants d'indication spécifique (15), (17), (19), (21) de l'armoire de l'appareil de commande électrique (14), (16), (18), (20), de sorte que l'unité d'indication (9) comporte un agencement de voyants avec des voyants à DEL de la même couleur, par exemple verte, utilisés avec différentes intensités de lumière pour indiquer des valeurs de rendement énergétique ou des niveaux de rendement énergétique spécifiques.

7. Appareil de commande électrique selon la revendication 6, **caractérisé en ce que** ladite manière d'aborder le rendement énergétique sélectionnée par l'utilisateur est basée sur les économies d'énergie récentes permises par un meilleur rendement énergétique comparées à une valeur de consommation maximum, à une valeur de consommation nominale ou à la consommation d'une autre commande électrique.

8. Appareil de commande électrique selon la revendication 6 ou la revendication 7, **caractérisé en ce que** le rendement énergétique déterminé est spécifié en tant que valeur de rendement énergétique spécifique ou niveau de rendement énergétique parmi un ensemble de niveaux de rendement énergétique.

9. Appareil de commande électrique selon l'une quelconque des revendications 6 à 8, **caractérisé en ce que** l'unité d'indication (9) utilise des voyants HPLED dans l'agencement de voyants.

10. Appareil de commande électrique selon l'une quelconque des revendications 6 à 9, **caractérisé en ce que** l'unité d'indication (9) comprend un agencement de guidage de lumière.

11. Appareil de commande électrique selon l'une quelconque des revendications 6 à 10, **caractérisé en ce que** l'unité d'indication (9) indique une panne ou un besoin de maintenance avec une couleur particulière sélectionnée.

12. Appareil de commande électrique selon l'une quelconque des revendications 6 à 11, **caractérisé en ce que** l'appareil de commande électrique (14), (16), (18), (20) est pourvu d'une possibilité de mettre à jour les valeurs standard applicables fixées au préalable pour le rendement énergétique.

13. Appareil de commande électrique selon l'une quelconque des revendications 6 à 12, **caractérisé en ce que** la zone de voyants d'indication (15), (17), (19), (21) se trouve dans la partie inférieure de l'armoire (15), dans la partie supérieure de l'armoire (17), dans la partie centrale de l'armoire (19), dans la zone s'étendant verticalement de la partie supérieure à la partie inférieure à l'avant de l'armoire (21), dans la zone avant de l'armoire (23) ou dans l'enceinte entière de l'armoire (25).

14. Appareil de commande électrique selon l'une quelconque des revendications 6 à 13, **caractérisé en ce que** l'appareil de commande électrique (14), (16), (18), (20) est un convertisseur de fréquence.
